# EUROPEAN PATENT APPLICATION

(11) **EP 4 092 167 A1**
(43) Date of publication of application: **23.11.2022**
(21) Application number: 22173232.4
(22) Date of filing: 13.05.2022
(51) Int. Cl.: C30B 13/28

(54) **INDUCTION HEATING COIL AND SINGLE CRYSTAL MANUFACTURING APPARATUS AND METHOD USING THE INDUCTION HEATING COIL**

(30) Priority: 18.05.2021 JP 2021083852
(71) Applicant: Sumco Corporation, Minato-ku, Tokyo 105-8634 (JP)
(72) Inventor: MATSUSHIMA, Naoki, Minato-ku, Tokyo (JP); YOKOYAMA, Ryusuke, Minato-ku, Tokyo (JP)
(74) Representative: Sticht, Andreas

(57) **Abstract**

Provided is an induction heating coil (20) that heats a raw material rod (2) in manufacturing a single crystal (4) by an FZ method. The induction heating coil (2) includes an annular-shaped coil conductor (21) having an opening (22) at its center; a slit (23) radially extending from the opening (22) to separate one end portion of the coil conductor (21) and the other end portion thereof from each other; and a radial step (25) formed on an upper surface (21A) of the coil conductor (25) . The upper surface (21A) of the coil conductor (21) has a step formation area (28) in which the step (25) is formed in a circular arc shape in a plan view so as to surround the opening (22) and a step non-formation area (29) having no step. The step non-formation area (29) includes a slit neighborhood (27A) adjacent to the slit (23) . The step formation area (28) is an area more distant from the slit (23) than the step non-formation area (29). The step (25) is formed near and radially inside the outer peripheral end (2e) of a straight body part of the raw material rod.

## Description

### FIELD OF THE INVENTION

The present invention relates to an induction heating coil used for manufacturing a single crystal using an FZ (Floating Zone) method and a single crystal manufacturing apparatus and method using the induction heating coil.

### BACKGROUND OF THE INVENTION

An FZ method is known as a manufacturing method for a silicon single crystal. In the FZ method, a part of a polycrystalline silicon raw material rod is heated to form a molten zone, and the raw material rod and a seed crystal positioned respectively above and below the molten zone are slowly lowered to grow a large single crystal above the seed crystal. Unlike a CZ method (Czochralski method), the FZ method does not use a quartz crucible and thus can manufacture a single crystal with a low oxygen concentration.

In the FZ method, an induction heating system is used to heat a polycrystalline silicon raw material. In the induction heating system, a magnetic field, which is generated when a high-frequency current is made to flow in an induction heating coil, is applied to a silicon raw material to cause an eddy current to flow in the silicon raw material through electromagnetic induction, thereby generating Joule heat due to the eddy current, and the generated Joule heat is used to heat the silicon raw material.

As to the method of heating the silicon raw material using the induction heating coil, Patent Document 1 (JP 2013-168345A) describes that a part of the back surface of the induction heating coil falling within a range of 20° or more and 80° or less centering on a slit is made flat, and a taper shape which becomes thicker from the center toward the outer periphery is formed in the part other than the flat part.

Further, Patent Document 2 (JP 2015-218076A) describes that a sub induction heating coil is installed at a position on the side opposite to an electrode (slit) for the main coil and between a main induction heating coil and a raw material and/or between the main induction heating coil and a single crystal, and the position of the sub induction heating coil is moved while observing a state of a floating zone so as to adjust the state of the floating zone that can influence on generation of dislocation.

Patent Document 3 (JP 2016-141612A) describes that a halogen lamp heater as an auxiliary heater is disposed above and/or below an induction heating coil so as to surround a raw material or a single crystal. Using the auxiliary heater allows the raw material to be efficiently heated. However, the halogen lamp heater disadvantageously heats even the induction heating coil, so that cooling limit of coolant flowing in the coil may be exceeded to bring about breakage of the coil due to boiling of the coolant.

For the FZ method, there has been a demand for a raw material rod having a large diameter in order to improve the yield of a single crystal. However, an increase in the diameter of the raw material rod makes it difficult to evenly heat the entire part in the peripheral direction of the raw material rod, thus generating a portion at which the melting amount of the raw material locally increases to increase a variation in height of the melted surface of the raw material in the peripheral direction. This uneven melted surface finally contacts the coil surface to result in interruption of the manufacturing process.

### SUMMARY OF THE INVENTION

It is therefore an object of the present invention to provide an induction heating coil capable of stably manufacturing a single crystal by reducing a variation in height of the melted surface of a raw material rod and a single crystal manufacturing apparatus and method using such an induction heating coil.

To solve the above problems, an induction heating coil according to the present invention is an induction heating coil that heats a raw material rod in manufacturing a single crystal by an FZ method, the coil including: an annular-shaped coil conductor having an opening at its center; a slit radially extending from the opening to separate one end portion of the coil conductor and the other end portion thereof from each other; and a radial step formed on the upper surface of the coil conductor. The upper surface of the coil conductor has a step formation area in which the step is formed in a circular arc shape in a plan view so as to surround the opening and a step non-formation area having no step. The step non-formation area includes a slit neighborhood adjacent to the slit. The step formation area is an area (slit non-neighborhood) more distant from the slit than the step non-formation area. The step is formed near and radially inside the outer peripheral end of a straight body part of the raw material rod.

A single crystal manufacturing apparatus according to the present invention is a single crystal manufacturing apparatus used for manufacturing a single crystal by an FZ method, the apparatus including: an upper shaft that rotatably and vertically movably supports a raw material rod; a lower shaft that is disposed below the upper shaft and rotatably and vertically movably supports a seed crystal; and an induction heating coil that heats the raw material rod, the induction hearting coil having the above-described feature.

A single crystal manufacturing method according to the present invention is a method that manufactures a single crystal by an FZ method with an induction heating coil having the above-described feature.

According to the present invention, a variation in the amount of heat generation between the slit neighborhood and the slit non-neighborhood can be reduced to evenly heat the outer peripheral portion of the raw material rod over the entire peripheral direction. This makes it possible to reduce a variation in the height of the melted surface of the raw material rod to thereby stably grow a single crystal.

In the present invention, a difference (Δr = r₀ - r₁) between a radius (r₀) of the raw material rod and a radius (r₁) of the step is preferably 2 mm or more and 8 mm or less. In this case, it is possible to evenly heat the outer peripheral portion of the raw material rod over the entire peripheral direction.

In the present invention, a height (h) of the step is preferably 0.5 mm or more and 1.5 mm or less. In this case, it is possible to increase current density near the step formation area to adequately increase the amount of heat generation.

In the present invention, the step non-formation area is preferably a fan-like area extending to both sides of the slit with a central angle of 45° or more and 90° or less. The step non-formation area defined at the one end portion side of the coil conductor and the step non-formation area defined at the other end portion side may be the same or different in size.

According to the present invention, there can be provided an induction heating coil capable of stably manufacturing a single crystal by reducing the height variation of the melted surface of a raw material rod and a single crystal manufacturing apparatus and method using such an induction heating coil.

### BRIEF DESCRIPTION OF THE DRAWINGS

FIG. 1 is a schematic view illustrating the configuration of a single crystal manufacturing apparatus according to an embodiment of the present invention.
FIGS. 2A and 2B are views illustrating the configuration of the induction heating coil according to a first embodiment of the present invention, in which FIG. 2A is a schematic top view, and FIG. 2B is a schematic cross-sectional view taken along the line X-X' in FIG. 2A.
FIG. 3 is a diagram illustrating a current flow in the induction heating coil.
FIGS. 4A and 4B are graphs each illustrating a simulation result of the distribution of the amount of heat generation in the raw material rod when heating is performed using a conventional induction heating coil, in which FIG. 4A illustrates the distribution of the amount of heat generation in the radial direction, and FIG. 4B illustrates the distribution of the amount of heat generation in the peripheral direction.
FIGS. 5A to 5E are views for explaining the relation between the step shape on the upper surface 21A of the induction heating coil 20 and the amount of heat generation.
FIGS. 6A and 6B are graphs each illustrating a simulation result of the distribution of the amount of heat generation in the raw material rod when heating is performed using the induction heating coil according to the present embodiment, in which FIG. 6A illustrates the distribution of the amount of heat generation in the radial direction, and FIG. 6B illustrates the distribution of the amount of heat generation in the peripheral direction.
FIG. 7 is a schematic top view illustrating the configuration of an induction heating coil according to a second embodiment of the present invention.

### DETAILED DESCRIPTION OF THE INVENTION

Hereinafter, preferred embodiments of the present invention will be described in detail with reference to the accompanying drawings.

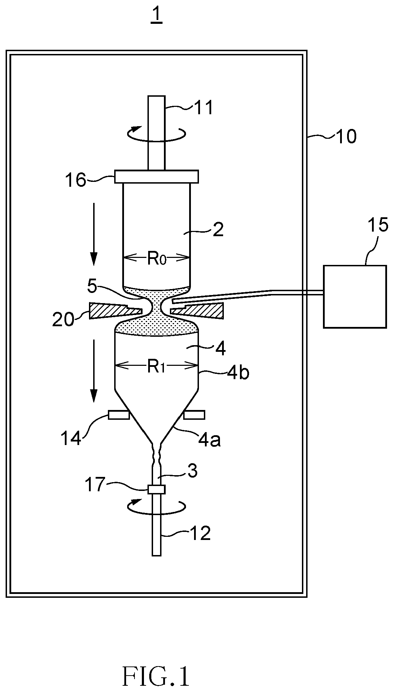

FIG. 1 is a schematic view illustrating the configuration of a single crystal manufacturing apparatus according to an embodiment of the present invention.

As illustrated in FIG. 1, a single crystal manufacturing apparatus 1 is an apparatus for growing a silicon single crystal by the FZ method. The single crystal manufacturing apparatus 1 includes: a reaction furnace 10 accommodating a raw material rod 2, a seed crystal 3, and a silicon single crystal 4 to be grown on the seed crystal 3; an upper shaft 11 that rotatably and vertically movably supports the raw material rod 2; a lower shaft 12 that rotatably and vertically movably supports the seed crystal 3 and silicon single crystal 4; an induction heating coil 20 for heating the lower end portion of the raw material rod 2; a single crystal weight holder 14 that abuts against a taper part 4a of the silicon single crystal 4 grown in size due to advance in crystal growth to support the weight of the silicon single crystal 4; and a gas doping apparatus 15 for supplying a doping gas to a molten zone (silicon melt) 5 between the raw material rod 2 and the silicon single crystal 4.

The raw material rod 2 is made from high-purity polycrystalline silicon obtained by purifying a silicon raw material such as monosilane or trichlorosilane and is attached, at its upper end portion, to the lower end portion of the upper shaft 11 through a raw material holder 16. The seed crystal 3 is attached, at its lower end portion, to the upper end portion of the lower shaft 12 through a seed crystal holder 17. The upper and lower shafts 11 and 12 are each rotated and vertically moved by a not-shown drive mechanism.

Typically, a diameter R₁ of the silicon single crystal 4 which is grown by FZ method is larger than a diameter R₀ of the raw material rod 2. For example, when the silicon single crystal 4 to be grown has a diameter R₁ of 200 mm, the raw material rod 2 to be used preferably has a diameter R₀ of 150 mm to 160 mm. The diameter R₁ of the silicon single crystal 4 refers to the diameter of a straight body part 4b of the silicon single crystal 4 that is the largest diameter in the silicon single crystal 4. Similarly, the diameter R₀ of the raw material rod 2 refers to the diameter of a straight body part of the raw material rod 2 that is the largest diameter in the raw material rod 2.

The induction heating coil 20 is a high-frequency coil of substantially one turn that surrounds the molten zone 5 or raw material rod 2 and is connected to a not-shown high-frequency oscillator. The induction heating coil 20 is preferably made of copper or silver. By supplying a high-frequency current to the induction heating coil 20, the lower end portion of the raw material rod 2 is induction-heated to thereby produce the molten zone 5. The seed crystal 3 is fused to the thus produced molten zone 5, and then the raw material rod 2 and silicon single crystal 4 are lowered while being rotated, whereby the silicon single crystal 4 can be grown from the molten zone 5.

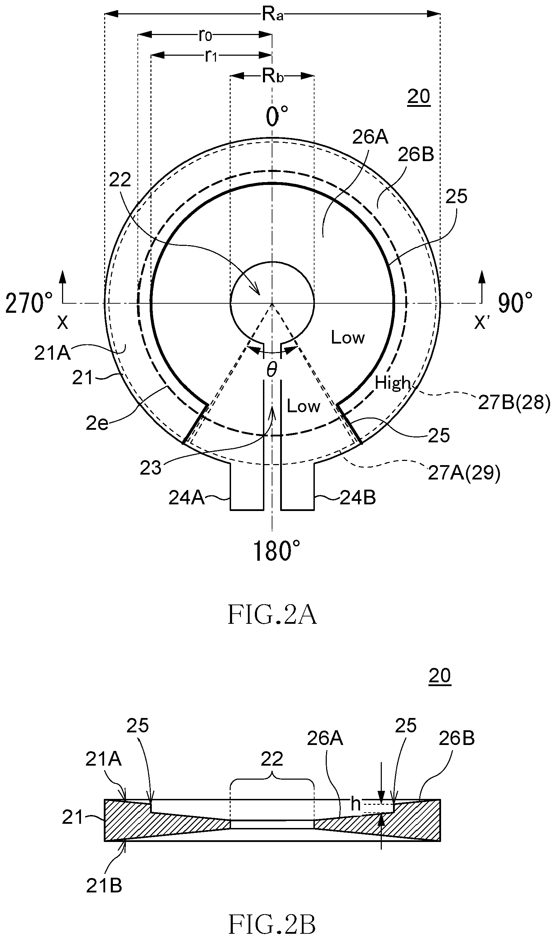

FIGS. 2A and 2B are views illustrating the configuration of the induction heating coil 20 according to a first embodiment of the present invention. FIG. 2A is a schematic top view, and FIG. 2B is a schematic cross-sectional view taken along the line X-X' in FIG. 2A.

As illustrated in FIGS. 2A and 2B, the induction heating coil 20 has a coil conductor 21 having a substantially flat annular shape, an opening 22 formed at the center of the coil conductor 21, a slit 23 radially extending from the opening 22 to the outer peripheral end to separate one end portion of the coil conductor 21 and the other end portion thereof from each other, and a pair of terminal electrodes 24A and 24B connected respectively to the one and the other end portions of the coil conductor 21. The coil conductor 21 is connected to the high-frequency oscillator through the terminal electrodes 24A and 24B.

Typically, an outer diameter Ra of the coil conductor 21 is larger than a diameter R₀ (= 2 × r₀) of the raw material rod 2, and an inner diameter Rb (diameter of the opening 22) of the coil conductor 21 is smaller than the diameter R₀ of the raw material rod 2. For example, when the raw material rod 2 has a diameter R₀ of 160 mm, the outer diameter Ra of the coil conductor 21 is larger than 160 mm, and the inner diameter Rb thereof is smaller than 160 mm.

An upper surface 21A of the coil conductor 21 may be a slope inclined upward from the inner circumferential side toward the outer peripheral side or may be a horizontal surface. A lower surface 21B of the coil conductor 21 is preferably a slope inclined downward from the inner circumferential side toward the outer peripheral side, but may be a horizontal surface.

The upper surface 21A of the coil conductor 21 includes a step 25 having a radius set in accordance with the radius of the raw material rod 2, a lower-level surface 26A in an area radially inward of the step 25, and an upper-level surface 26B in an area radially outward of the step 25. The upper-level surface 26B is formed so as to be higher than the lower-level surface 26A. The lower surface 21B of the coil conductor 21 is not particularly limited in shape and may be a stepless, flat surface.

As illustrated in FIG. 2A, the step 25 is formed into a circular arc shape in a plan view so as to surround the opening 22 and is positioned radially inward of an outer peripheral end 2e of the straight body part of the raw material rod 2. When the radius of the straight body part of the raw material rod 2 is r₀ and that the radius of the step 25 is r₁, a difference Δr (= r₀ - r₁) between r₀ and r₁ is preferably 2 mm or more and 8 mm or less. When the step 25 is positioned excessively close to the outer peripheral end 2e of the raw material rod 2 or positioned outside the outer peripheral end 2e, the effect of supplementing the amount of heat generation becomes small; when the step 25 is positioned excessively close to the inner peripheral side of the raw material rod 2, influence on a local minimum position of the amount of heat generation becomes small.

For example, when the raw material rod 2 has a diameter of 160 mm, the step 25 is positioned in a range of 72 mm to 78 mm in the radial direction from the center of the coil conductor 21. When the raw material rod 2 has a diameter of 150 mm, the step 25 is positioned in a range of 67 mm to 73 mm in the radial direction from the center of the coil conductor 21. In particular, when the step 25 is defined in a range of 72 mm to 73 mm in the radial direction from the center of the coil conductor 21, applicable range of the diameter of the raw material rod 2 can be widen to a range of 150 mm to 160 mm.

A height h of the step 25 is preferably 0.5 mm or more and 1.5 mm or less. When the height h of the step 25 is excessively low, the effect of the step 25 is not observed; when the height h of the step 25 is excessively high, the effect of increasing current density near the formation position of the step 25 becomes small.

The step 25 is formed over the entire part in the peripheral direction on the upper surface 21A of the coil conductor 21 except a slit neighborhood 27A. That is, the slit neighborhood 27A has no step. The slit neighborhood 27A is defined as a fan-like area extending to both sides of the slit 23 with a central angle of 45° or more and 90° or less (± 22.5° or more and ± 45° or less) .

As illustrated in FIG. 2A, the terminal end part of the step 25 having a circular arc shape in a plan view extends to the outer peripheral end of the coil conductor 21. The radially extending part of the step 25 does not contribute to adjustment of the heating distribution for the raw material rod 2, so that the step surface may be gently inclined.

The upper surface 21A of the coil conductor 21 is roughly divided into the slit neighborhood 27A adjacent to the slit 23 and a slit non-neighborhood 27B more distant from the slit 23 than the slit neighborhood 27A, and the step 25 is included in the slit non-neighborhood 27B. That is, a step formation area 28 where the step 25 is formed so as to surround the opening 22 is included in the slit non-neighborhood 27B. Further, the slit neighborhood 27A constitutes a step non-formation area 29 where the step 25 is absent. The step formation area 28 is constituted of the lower-level surface 26A and upper-level surface 26B, while the step non-formation area 29 is constituted of only the lower-level surface 26A and has an entirely flat surface.

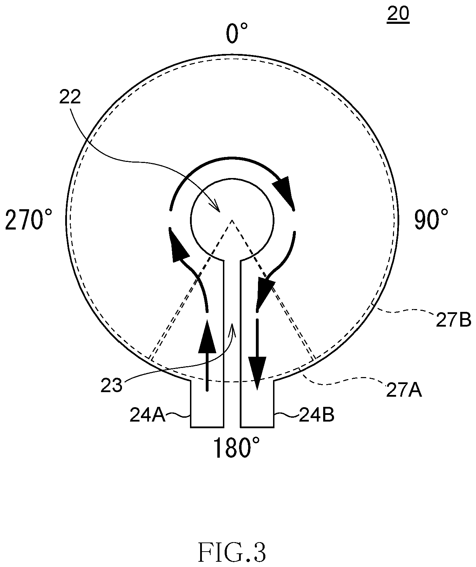

As denoted by the arrows in FIG. 3, in the induction heating coil 20, current flows along a path that connects the pair of terminal electrodes 24A and 24B with the shortest distance. Accordingly, in the slit non-neighborhood 27A, current density becomes high to increase the amount of heat generation. On the other hand, in the slit non-neighborhood 27B, more current flows near the inner peripheral end (opening 22) of the coil conductor 21, so that the amount of heat generation is small near the outer peripheral end of the raw material rod 2. Thus, the outer peripheral portion of the raw material rod 2 is heated unevenly in the peripheral direction, making it difficult to melt the raw material rod 2 evenly in the peripheral direction.

However, when the radial step 25 is formed on the entire upper surface 21A of the coil conductor 21 except the slit non-neighborhood 27A, the current density near the formation position of the step 25 can be increased to increase the amount of heat generation, making it possible to evenly heat the outer peripheral portion of the raw material rod 2 in the peripheral direction. Thus, sagging of a part of the melted surface can be prevented.

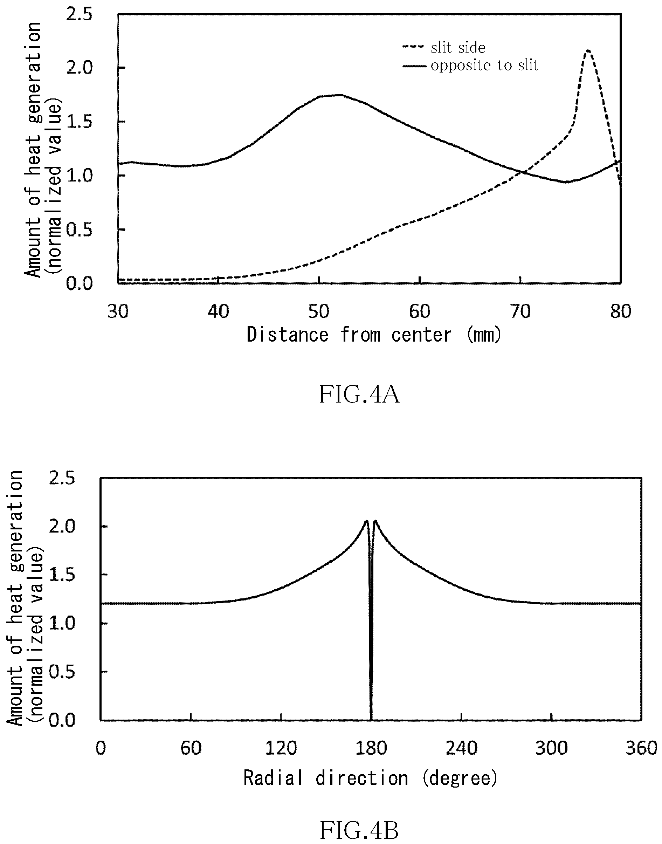

FIGS. 4A and 4B are graphs each illustrating a simulation result of the distribution of the amount of heat generation in the raw material rod when heating is performed using a conventional induction heating coil. FIG. 4A illustrates the distribution of the amount of heat generation in the radial direction, and FIG. 4B illustrates the distribution of the amount of heat generation in the peripheral direction.

As illustrated in FIG. 4A, when heating is performed on the side (0° position) opposite to the slit of the induction heating coil 20, the amount of heat generation varies a little in the radial direction; on the other hand, when heating is performed on the slit side (180° position), the difference in the amount of heat generation between the inside and outside in the radial direction is significantly large. Further, as illustrated in FIG. 4B, the amount of heat generation in the peripheral direction of the induction heating coil becomes maximum near the slit and becomes smaller on the side opposite to the slit than near the slit.

As described above, the distribution of the amount of heat generation in the raw material rod is not even in the peripheral direction, so that the raw material rod cannot be melted evenly in the peripheral direction, which may cause sagging of a part of the melted surface or may cause icicle-like melted residues. This brings about a risk of contact between the melted surface or melted residues and the induction heating coil 20 or electric discharge therebetween.

In view of this, in the present embodiment, the step is formed on the upper surface of the induction heating coil which is positioned immediately below the vicinity of the outer peripheral portion of the raw material rod 2. Thus, current flows along the side surface of the step to increase current density near the formation position of the step 25, with the result that heating effect increases near the step. However, it is not desirable to increase heat generation effect in the slit neighborhood 27A, so that the step is not formed therein. Thus, the coil shape as illustrated in FIGS. 2A and 2B is obtained.

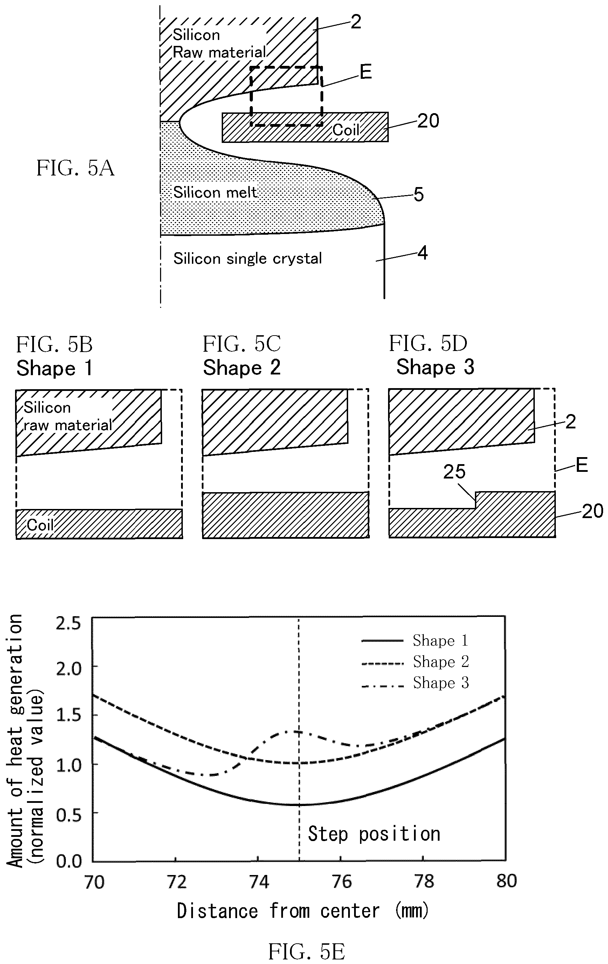

FIGS. 5A to 5E are views for explaining the relation between the step shape on the upper surface 21A of the induction heating coil 20 and the amount of heat generation.

FIG. 5A illustrates the positional relation between the raw material rod 2 and the induction heating coil 20, and FIGS. 5B to 5D illustrate in an enlarged manner the coil shape at a portion (surrounded by the dashed line E in FIG. 5A) near the outer peripheral portion of the raw material rod 2. FIG. 5B (shape 1) illustrates a case where the coil upper surface is flat and where the distance between the coil upper surface and the raw material rod is large, FIG. 5C (shape 2) illustrates a case where the coil upper surface is flat and where the distance between the coil upper surface and the raw material rod is small, and FIG. 5D (shape 3) illustrates a case where a step is formed on the coil upper surface. FIG. 5E is a graph illustrating the distributions of the amount of heat generation in the radial direction of the raw material rod 2 obtained respectively when the coils of the shapes 1 to 3 illustrated in FIGS. 5B to 5D are used. In this graph, the horizontal axis represents a distance (mm) from the center of the raw material rod, and the vertical axis represents the amount of heat generation (normalized value).

When the coil upper surface is flat as in FIGS. 5B and 5C, the amount of heat generation in the radial direction near the outer peripheral portion of the raw material rod becomes the local minimum at a 75 mm position slightly inside the outer peripheral end (80 mm) of the raw material rod. In this case, when the distance between the raw material rod and the coil upper surface is large as in FIG. 5B (shape 1), the distribution of the amount of heat amount becomes low as a whole, while when the distance between the raw material rod and the coil upper surface is small as in FIG. 5C (shape 2), the distribution of the amount of heat amount becomes large as a whole. Thus, even when the distance between the raw material rod and the coil upper surface is changed, the variation in the amount of heat generation cannot be reduced.

However, when a step is formed at a 75 mm position at which the amount of heat generation becomes the local minimum as in FIG. 5D (shape 3), the amount of heat generation locally increases at this position, thus making it possible to reduce a deviation in the distribution of the amount of heat generation as illustrated in FIG. 5E.

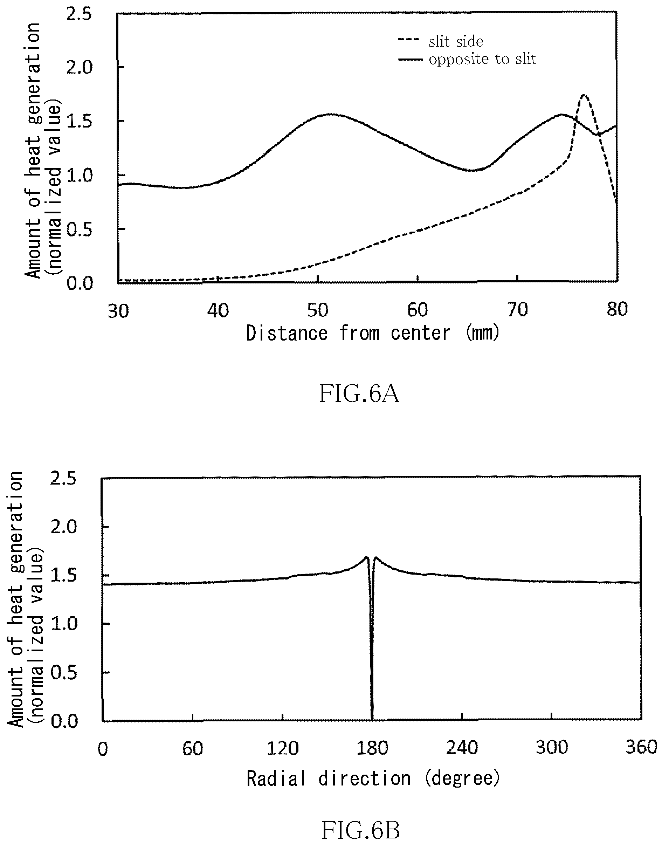

FIGS. 6A and 6B are graphs each illustrating a simulation result of the distribution of the amount of heat generation in the raw material rod when heating is performed using the induction heating coil according to the present embodiment. FIG. 6A illustrates the distribution of the amount of heat generation in the radial direction, and FIG. 6B illustrates the distribution of the amount of heat generation in the peripheral direction.

A comparison between FIG. 6A and FIG. 4A reveals that, when the induction heating coil 20 according to the present embodiment is used, a difference in the amount of heat generation between the inside and outside in the radial direction when heating is performed at the slit side (180° position) is reduced. Further, a comparison between FIG. 6B and FIG. 4B reveals that, in the distribution of the amount of heat generation in the peripheral direction of the induction heating coil, the steep peak on both sides of the slit is reduced to reduce the variation in the amount of heat generation.

As described above, in the induction heating coil 20 according to the present embodiment, the radial step 25 is formed on the upper surface 21A of the coil conductor 21 except the area neighboring the slit, and the radial position of the step 25 is set slightly inside the outer peripheral end of the raw material rod 2, so that the distribution of the amount of heat generation in the peripheral direction of the raw material rod 2 can be made even. This makes it possible to reduce a variation in the height of the melted surface of the raw material rod in the peripheral direction and thereby to improve a dislocation-free success rate.

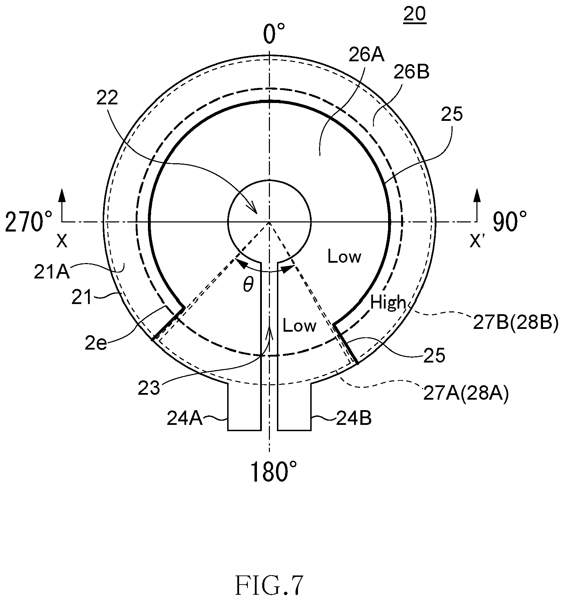

FIG. 7 is a schematic top view illustrating the configuration of an induction heating coil according to a second embodiment of the present invention.

As illustrated in FIG. 7, the induction heating coil 20 according to the present embodiment is featured in that the step non-formation area 29 is defined near the slit 23 so as to be left-right asymmetrical with respect to the slit 23. Other configurations are the same as those in the first embodiment. In the present embodiment, although the step non-formation area 29 extending toward one end side (first terminal electrode 24A side) of the coil conductor 21 is set larger in size than the step non-formation area 29 extending toward the other end side (second terminal electrode 24B side), this magnitude relationship may be reversed.

As illustrated in FIG. 6B, forming the radial step 25 on the upper surface 21A of the coil conductor 21 except the area neighboring the slit allows improvement in the heat generation distribution in the peripheral direction; however, the amount of heat generation near the slit is still large. Then, as illustrated in FIG. 7, the step non-formation area 29 on the upstream side relative to the slit in the rotation direction of the raw material rod is set smaller in size, so that the melting amount of the raw material can be increased in a part of the slit neighborhood that is located on the upstream side relative to the slit. As a result, as compared to when the step non-formation area 29 on the upstream side (second terminal electrode 24B side) and that on the downstream side (first terminal electrode 24A side) are the same in size, the amount of heat generation near the slit can be reduced. Thus, it is possible to avoid the raw material from being excessively melted near the slit.

As described above, in the induction heating coil 20 according to the present embodiment, even though the step non-formation areas 29 located on both sides of the slit 23 are made different in size, the same effects as those in the first embodiment can be obtained.

While the preferred embodiments of the present invention have been described, the present invention is not limited to the above embodiments, and various modifications may be made within the scope of the present invention, and all such modifications are included in the present invention.

For example, although one-stage step is formed in the above embodiments, two-or-more-stage step may be formed. Further alternatively, a groove or a projection constituted by a combination of a descending step and an ascending step may be formed.

Further, although a case where a silicon single crystal is manufactured has been described in the above embodiments, the present invention may be applied to the manufacture of various single crystals manufactured using the FZ method.

### EXAMPLES

The coil shape was studied for the purpose of improving the yield of manufacturing of a silicon single crystal according to the FZ method. A polycrystalline silicon with a diameter of 160 mm was used as a raw material rod to grow a silicon single crystal with a diameter of 200 mm.

### <Study of Step Height in Coil>

The height h of the step formed on the upper surface of the induction heating coil was studied. The step was formed on the entire upper surface of the coil conductor except the slit neighborhood at the radial position of 75 mm from the coil center. The slit neighborhood was defined as a fan-like area extending to both sides of the slit with a central angle of 60° (± 30°), and the thus defined slit neighborhood was set as the step non-formation area. The height h of the step was set to five values, 0 mm (no step), 0.5 mm, 1.0 mm, 2.0 mm, and 4.0 mm. Then, five crystals were grown for each coil. The results are shown in Table 1.

**[Table 1]**

| | | | | | | |
|---|---|---|---|---|---|---|
| Step height H | 0 mm | 0.5 mm | 1.0 mm | 1.5 mm | 2.0 mm | 4.0 mm |
| Number of successes of dislocation-free | 3 | 4 | 5 | 4 | 3 | 0 |

As shown in Table 1, the number of successes of dislocation-free was three for a conventional coil having a stepless, flat upper surface. On the other hand, for coils respectively having a step height h = 0.5 mm, 1.0 mm, and 1.5 mm, the number of successes of dislocation-free was four or more. Thus, the dislocation-free success rate was improved as compared to the conventional coil having a stepless, flat upper surface. In particular, the number of successes of dislocation-free was five for a coil having a step height h = 1.0 mm, which was the most favorable result.

On the other hand, the number of successes of dislocation-free was three for a coil having a step height h = 2 . 0 mm, which was similar to the result for the conventional coil having no step. When h = 2.0 mm, the melting amount of the raw material increases at the position on the side opposite to the slit, and the raw material was melted unevenly in the peripheral direction as compared to a case of h = 1.0 mm. When the step height h = 4.0 mm, the raw material was melted more unevenly in the peripheral direction, and the growing process was stopped after two times of execution to avoid a risk of contact between the raw material and the coil. Thus, the number of successes of dislocation-free was zero.

The above results reveal that the step height h preferably ranges from 0.5 mm to 1.5 mm, and 1.0 mm is desirable.

### <Study of Size of Step Non-formation Area>

The size of the step non-formation area defined near the slit was studied. The same crystal growth conditions as those for the above-described study of the height of the coil step were used. The height h of the step was set to 1.0 mm.

The step non-formation area was defined as a fan-like area extending to both sides of the slit with a central angle θ. The central angle θ was set to five values, 0° (step was formed over the entire periphery), 45°, 60°, 90°, and 180°. Then, five crystals were grown for each coil. The results are shown in Table 2.

**[Table 2]**

| | | | | | |
|---|---|---|---|---|---|
| Central angle θ | 0° | 45° | 60° | 90° | 180° |
| Number of successes of dislocation-free | 1 | 4 | 5 | 4 | 3 |

As shown in Table 2, the number of successes of dislocation-free was four or more for the central angle θ = 45°, 60°, and 90°. Thus, the dislocation-free success rate was improved as compared to the conventional coil. In particular, the number of successes of dislocation-free was five for the central angle θ = 60°, which was the most favorable result.

On the other hand, the number of successes of dislocation-free was three for the central angle θ = 180°, which was similar to the result for the conventional coil having no step. When the central angle θ = 0°, the number of successes of dislocation-free was one. That is, when the step was formed over the entire periphery of the coil, large heat generation near the slit was highlighted, causing unstable melting of the raw material.

### <Study of Radial Position of Coil Step (raw material diameter = 160 mm)>

A preferred radial position of the step was studied for a raw material having a diameter of 160 mm. From the above obtained results, the step height h was set to 1.0 mm, and the central angle θ of the step non-formation area was set to 60°.

The radial distance L from the center of the coil conductor to the formation position of the step, i.e., the radius r₁ (see FIG. 2A) of the circular arc step was set to six values, 70 mm, 72 mm, 75 mm, 78 mm, 80 mm, and 82 mm. Then, five silicon single crystals were grown for each coil. The distance from the outer peripheral end of the raw material to the formation position of the step was set to six values, -10 mm, -8 mm, -5 mm, -2 mm, 0 mm, and +2 mm. Then, five crystals were grown for each coil. The results are shown in Table 3.

**[Table 3]**

| | | | | | | |
|---|---|---|---|---|---|---|
| Distance L from center | 70 mm | 72 mm | 75 mm | 78 mm | 80 mm | 82 mm |
| Distance from raw material end | -10 mm | -8 mm | -5 mm | -2 mm | 0 mm | +2 mm |
| Number of successes of dislocation-free | 2 | 4 | 5 | 4 | 3 | 3 |

As shown in Table 3, the number of successes of dislocation-free was four or more for the distance L up to the step = 72 mm, 75 mm, and 78 mm. Thus, the dislocation-free success rate was improved as compared to the conventional coil. In particular, the number of successes of dislocation-free was five for the distance L = 75 mm, which was the most favorable result.

On the other hand, the number of successes of dislocation-free was three for the distance L up to the step = 80 mm and 82 mm, which was similar to the result for the conventional coil having no step. When the position of the step coincides with the outer peripheral end of the raw material rod or outside thereof, the effect of the step was not obtained.

When the distance L up to the step = 70 mm, i.e., when the step was formed at a 10 mm position inward from the outer peripheral end of the raw material rod, the effect of the step was not observed, and the number of successes of dislocation-free decreased. This is considered to be because heat concentrates not at the outer peripheral portion of the raw material rod but at the inside thereof to further deteriorate heat distribution.

The above results reveal that the radial position of the step is preferably in the range of 2 mm to 8 mm inward from the outer peripheral end of the raw material rod, and 5 mm is desirable.

### <Study of Radial Position of Coil Step (raw material diameter = 150 mm) >

A preferred radial position of the step was studied for a raw material rod having a diameter of 150 mm. As in the case of using the raw material rod having a diameter of 160 mm, the step height h was set to 1.0 mm, and the central angle θ of the step non-formation area was set to 60°.

The radial distance L from the center of the coil conductor to the formation position of the step was set to five values, 65 mm, 67 mm, 70 mm, 73 mm, and 75 mm. Then, five silicon single crystals were grown for each coil. The distance from the outer peripheral end of the raw material to the formation position of the step was set to five values, -10 mm, -8 mm, -5 mm, -2 mm, and 0 mm. Further, evaluation was made for a coil having a stepless, flat upper surface under the same conditions. The results are shown in Table 4.

**[Table 4]**

| | | | | | | |
|---|---|---|---|---|---|---|
| Distance L from center | Flat | 65 mm | 67 mm | 70 mm | 73 mm | 75 mm |
| Distance from raw material end | Flat | -10 mm | -8 mm | -5 mm | -2 mm | 0 mm |
| Number of successes of dislocation-free | 4 | 3 | 4 | 5 | 4 | 4 |

As shown in Table 4, the dislocation-free success rate was higher when the conventional coil having a stepless, flat upper surface was used for a raw material rod having a diameter of 150 mm than when the conventional coil having a stepless, flat upper surface was used for a raw material rod having a diameter of 160 mm and four out of five trials (80%) were successful. When the position of the step was 65 mm, that is, when the step was formed at a 10 mm position inward from the outer peripheral end of the raw material rod, the number of successes of dislocation-free was three, i.e., the dislocation-free success rate deteriorated.

The dislocation-free success rate is originally high when the raw material having a diameter of 150 mm is used, so that the effect of the step cannot be clearly demonstrated; however, Table 4 reveals the same result as that obtained when the raw material rod having a diameter of 160 mm is used. That is, the radial position of the step is preferably in the range of 2 mm to 8 mm inward from the outer peripheral end of the raw material rod, and 5 mm is most desirable.

## Claims

1. An induction heating coil that heats a raw material rod(2) in manufacturing a single crystal (4) by an FZ method, comprising:
an annular-shaped coil conductor (21) having an opening (22) at its center;
a slit (23) radially extending from the opening (22) to separate one end portion of the coil conductor (21) and the other end portion thereof from each other; and
a radial step (25) formed on an upper surface (21A) of the coil conductor (25), wherein
the upper surface (21A) of the coil conductor (21) has a step formation area (28) in which the step (25) is formed in a circular arc shape in a plan view so as to surround the opening (22) and a step non-formation area (29) having no step,
the step non-formation area (29) includes a slit neighborhood (27A) adjacent to the slit (23),
the step formation area (28) is an area more distant from the slit (23) than the step non-formation area (29), and
the step (25) is formed near and radially inside the outer peripheral end (2e) of a straight body part of the raw material rod (2).

2. The induction heating coil according to Claim 1, wherein a difference between a radius (r₀) of the raw material rod (2) and a radius (r₁) of the step (25) is 2 mm or more and 8 mm or less.

3. The induction heating coil according to Claim 1 or 2, wherein a height (h) of the step (25) is 0.5 mm or more and 1.5 mm or less.

4. The induction heating coil according to any one of Claims 1 to 3, wherein the step non-formation area (29) is a fan-like area extending to both sides of the slit (23) with a central angle of 45° or more and 90° or less.

5. The induction heating coil according to any one of Claims 1 to 4, wherein the step non-formation area (29) defined at the one end portion side of the coil conductor (21) and the step non-formation area (29) defined at the other end portion side is different in size.

6. A single crystal manufacturing apparatus (1) used for manufacturing a single crystal (4) by an FZ method, comprising:
an upper shaft (11) that rotatably and vertically movably supports a raw material rod (2);
a lower shaft (12) that is disposed below the upper shaft (11) and rotatably and vertically movably supports a seed crystal (3); and
an induction heating coil (20) according to any one of Claim 1 to 5 that heats the raw material rod (2).

7. A single crystal manufacturing method that manufactures a single crystal (4) by an FZ method with an induction heating coil (20) according to any one of Claims 1 to 5.
